# EUROPÄISCHE PATENTSCHRIFT

(11) **EP 2 016 480 B1**
(45) Veröffentlichungstag und Bekanntmachung des Hinweises auf die Patenterteilung: **23.10.2013**
(21) Anmeldenummer: 07724726.0
(22) Anmeldetag: 30.04.2007
(51) Int. Cl.: H01H 25/04, H03K 17/96, G06F 3/042

(54) **OPTOELEKTRONISCHE VORRICHTUNG ZUR ERFASSUNG DER POSITION UND/ODER BEWEGUNG EINES OBJEKTS SOWIE ZUGEHÖRIGES VERFAHREN**
OPTOELECTRONIC DEVICE FOR THE DETECTION OF THE POSITION AND/OR MOVEMENT OF AN OBJECT, AND ASSOCIATED METHOD
DISPOSITIF OPTOÉLECTRONIQUE POUR SAISIR LA POSITION ET/OU LE MOUVEMENT D'UN OBJET ET PROCÉDÉ ASSOCIÉ

(30) Priorität: 01.05.2006 DE 102006020570
(43) Veröffentlichungstag der Anmeldung: 21.01.2009
(73) Patentinhaber: Mechaless Systems GmbH, 76646 Bruchsal (DE)
(72) Erfinder: REIME, Gerd, 77815 Bühl (DE)
(74) Vertreter: Durm & Partner
(86) Internationale Anmeldenummer: PCT/EP2007/003799
(87) Internationale Veröffentlichungsnummer: WO 2007/124943

(56) Entgegenhaltungen:
- WO-A-2005/019987
- US-A- 4 806 749
- US-A1- 2002 020 808
- US-A1- 2004 140 960

## Beschreibung

Die Erfindung betrifft eine optoelektronische Vorrichtung zur Erfassung der Position und/oder Bewegung eines Objekts, die insbesondere für die Steuerung und/oder Bedienung von Computern oder Vorrichtungen verwendet werden kann, nach dem Oberbegriff des Anspruches 1 sowie ein zugehöriges Verfahren nach dem Oberbegriff des Anspruches 9.

Grundsätzlich sind verschiedenartige Bedienelemente für Steuerungen bekannt, die insbesondere für die Steuerung von Computern verwendet werden. Am häufigsten verwendet wird eine Maus, die als zusätzliches Element an einem Computer angeschlossen wird und deren Relativbewegung zu einer Oberfläche in eine Bewegung eines Cursors umgesetzt wird, mit dem Bedienfelder auf dem Bildschirm des Computers angesteuert werden können. Auf ähnliche Weise arbeiten die insbesondere in Notebooks integrierten berührungssensitiven Oberflächen oder Scrollbälle.

Aus der US 2002/0020808 A1 ist eine optoelektronisch arbeitende Vorrichtung zur Erfassung der Position und/oder Bewegung eines Objekts mit mehreren Sendern und einem Empfänger zum Empfangen der von den Sendern ausgesandten und vom Objekt beeinflussbaren Strahlung bekannt. Zwischen Sender und Empfänger werden mehrere voneinander verschiedene Strahlungsstrecken gebildet, die ein Lichtfeld bilden. Die Strahlungsstrecken werden sequenziell geschaltet, wobei im Bereich der Strahlungsstrecken eine Bedienoberfläche angeordnet ist. Über eine Auswerteeinheit werden die vom Empfänger aus den Strahlungsstecken empfangenen Signale in Werte zur Erfassung der Position und/oder der Bewegung des Objekts im Lichtfeld umgesetzt. Das Lichtfeld ist der Bedienoberfläche zugeordnet, so dass die Auswerteeinheit in Folge der Bewegung eines Betätigungselements erkennen kann, ob eine Strahlungsstrecke im Lichtfeld unterbrochen wurde. Erkannt wird eine Betätigung durch ein Objekt auf der Oberfläche des Betätigungselements.

Aus der US 4,806,749 A ist ein auf der Unterbrechung von über einer Bedienoberfläche angeordneten Lichtschranken beruhendes Positionserfassungssystem bekannt. Strahlungsstrecken gebildet von Sendern und Empfängern werden sequenziell betrieben und die aus den Strahlungsstecken kommenden Signale werden zur Erfassung der Position und/oder der Bewegung eines Objekts im Lichtfeld umgesetzt. Eine vergleichbare Lösung ist aus der US 2004/0140960 A1 im Form eines berührungsempfindlichen Bildschirms zur Eingabe von Zusatzfunktionen ebenfalls bekannt.

Aus der WO 2005/019987 A2 ist eine Eingabeeinrichtung bekannt, die ein bewegliches Touchpad aufweist, das dazu geeignet ist, ein Objekt in seiner Nähe zu detektieren, um ein erstes Regelsignal zu erzeugen. Ergänzend ist ein Bewegungsdetektor vorhanden, um mehrere verschiedene Zusatzsignale zu erzeugen. Die Vorrichtung kann optoelektronisch betrieben werden.

Aus der EP 1 410 507 B1 ist eine optoelektronisch arbeitende Vorrichtung bekannt, bei der einerseits Bewegungen über einer Oberfläche in x- und γ-Richtung erfasst werden, zusätzlich jedoch auch die Entfernung z. B. eines Finger von der Oberfläche in der dritten Dimension erkannt werden kann und dadurch z.B. bei einem Navigationssystem in das Bild zu zoomen. Das dort vorgeschlagene System geht von der EP 0 706 648 B1 aus, die ein optisches Meßsystem vorschlägt, bei dem mindestens zwei Leuchtdioden als Lichtquellen Licht wechselseitig so aussenden, dass in einem Empfänger ein Gleichlichtsignal ohne taktsynchrone Wechsellichtanteile anliegt. Dieses System wird allgemein zur Positions- und Abstandsmessung eingesetzt. Sind zwei Lichtquellen, z.B. in Form von LEDs, und ein Empfänger vorgesehen, reflektiert ein über den optoelektronischen Elementen befindlicher Gegenstand Licht von den LEDs zum Empfänger. Die Schaltung ist so aufgebaut, dass Fremdlicht keinen Einfluss hat und Lichtsignale deutlich wahrgenommen werden können, die z.B. aus den zwischen Lichtquelle und Empfänger bestehenden Lichtstrecken stammen. Bei diesem Prinzip werden beide Lichtquellen in ihrer Intensität so geregelt, dass der Empfänger sie mit gleicher Intensität sieht. Das Verhältnis der hierzu notwendigen LED-Ströme entspricht der optischen Übertragung der beiden Strecken. Die Regelung steuert die Betriebsströme der beiden LEDs stets gegensinnig, so dass eine Ausregelung der Empfangssignale zu Null erfolgt. Dieses System wird in der EP 1 410 507 B1 dadurch weitergebildet, dass dort ein Feld mit vier LEDs aufgebaut wird, wobei zusätzlich zu den getakteten Lichtsignalen zur zweidimensionalen Erfassung in einem weiteren Takt Licht ausgesandt wird, um auch eine Entfernung in der dritten Dimension, d.h. einen Abstand von der Fläche zu erkennen.

Dieses System kann unter anderem auch verwendet werden, um ein Maus-ähnliches Bedienelement zu schaffen, bei dem eine kreisförmige Bewegung einer Fingerkuppe erkannt wird.

Die vier Sender erkennen den Abstand des Fingers von den LEDs und können aus diesem Signal bestimmen, wo sich der Finger bzw. die Maus gerade befindet.

In ähnlicher Weise wurde dieses Prinzip bei der DE 103 00 224 A1 dafür eingesetzt, um eine Rotationsbewegung eines Drehknopfs oder auch lediglich die Geste einer Hand als Bedienfunktion zu erkennen.

Da diese Bedienelemente meist jedoch wie eine Maus eingesetzt werden sollen, besteht das Bedürfnis, wie bei einer Maus auch über Zusatztasten eine Zusatzfunktionen zu betätigen. Dies ist grundsätzlich nach dem Stand der Technik dadurch möglich, dass unter einem Bedienelement zusätzliche Kontakte vorgesehen werden, durch die eine Tastenfunktion gewährleistet wird. Dafür sind allerdings wiederum zusätzliche mechanische Vorrichtungen erforderlich, die allein durch Verschmutzung und Alterung in ihrer Bedienbarkeit eingeschränkt sein können.

Ausgehend von diesem Stand der Technik liegt der vorliegenden Erfindung die Aufgabe zugrunde, eine optoelektronische Vorrichtung zu schaffen, die als Bedienelement zusätzlich zur Positionserkennung eine eindeutige Bedienbarkeit von Zusatzfunktionen erlaubt.

Diese Aufgabe wird durch eine optoelektronische Vorrichtung mit den Merkmalen des Anspruches 1 und durch ein Verfahren zur optoelektronischen Erfassung mit den Merkmalen des Anspruches 9 gelöst.

Zusätzlich zur Erkennung der Position und/oder Bewegung im zweidimensionalen Raum wird überprüft, ob im Lichtfeld, in dem die Erkennung in x- und/oder y-Richtung erfolgt, an einer Stelle eine Strahlungsstrecke unterbrochen wird. Wird eine derartige absorptive Unterbrechung festgestellt, ist in diesem Sektor ein "Eingriff" durch das Objekt oder ein Betätigungselement erfolgt. Dieser "Eingriff" wird als Tastenfunktion bzw. als Zusatzfunktion ausgewertet. Dadurch kann einerseits, wenn gewünscht, auf mechanische Hilfsmittel verzichtet werden, denn es wird lediglich in einem Lichtfeld überprüft, ob und in wie weit dort eine Position von Objekt oder Betätigungselement erreicht ist oder eine Bewegung erfolgt. Will der Anwender andererseits tatsächlich eine Tastenfunktion z.B. zum Bestätigen seiner Auswahl auf einem Bildschirm vornehmen, "tastet" er, falls das Objekt ein Finger ist, entweder mit dem Finger oder dem Betätigungselement auf die Bedienoberfläche durch, was als absorptive Unterbrechung erkannt wird, da in diesem Moment von zumindest einem der das Lichtfeld aufbauenden Sender am Empfänger kein Empfangssignal mehr ankommt. Dabei sind Mittel vorgesehen, durch die die Strahlung in mehrere Lichtfelder aufgeteilt wird, von denen sich eines (L) über der Bedienoberfläche und eines (L') unter dem Betätigungselement befindet. Über der Bedienoberfläche kann so die Bewegung und/oder Position des Objekts im Lichtfeld L bestimmt werden. Es kann auch in diesem Lichtfeld eine absorptive Unterbrechung erkannt werden. Ferner kann die Position und/oder Bewegung des Betätigungselements im Lichtfeld L', meist durch eine Betätigung durch das Objekt O wie z.B. einen Finger ausgelöst, ebenso erkannt werden, wie eine absorptive Unterbrechung im Lichtfeld L'.

Vorzugsweise entspricht damit die Anzahl der Sender auch der Anzahl der möglichen Zusatzfunktionen. Ergänzend kann jedoch auch ein Teil des Lichts der Sender bewusst über Lichtleiter zwischen zwei benachbarte, den Lichtquellen zugeordnete Felder geleitet werden, so dass beim Ausbleiben genau dieses Lichtanteils ebenfalls auf eine absorptive Unterbrechung in diesem Bereich zu schließen ist, d.h. es können weitere Zusatzfunktionen geschaffen werden.

Weitere Vorteile ergeben sich aus den Unteransprüchen und der nachfolgenden Beschreibung.

Im folgenden wird die Erfindung anhand von in den Figuren dargestellten Ausführungsbeispielen erläutert. Es zeigen:
- Fig. 1: Ein Schnitt nach Linie 1-1 von Fig. 2 durch eine optoelektronische Vorrichtung zur Erfassung der Position und/oder Bewegung eines Fingers als Objekt O,
- Fig. 2: eine Draufsicht auf die Vorrichtung gemäß Fig. 1,
- Fig. 3: eine Draufsicht gemäß Fig. 2 in einem weiteren Ausführungsbeispiel,
- Fig. 4: ein Signal bei einer absorptiven Unterbrechung,
- Fig. 5: ein beispielhaftes Blockschaltbild für eine zugehörige Schaltung,
- Fig. 6: einen Schnitt durch die optoelektronischen Vorrichtung in einem dritten Ausführungsbeispiel,
- Fig. 7: eine Explosionsdarstellung der Vorrichtung gemäß Fig. 6.

Bevor die Erfindung im Detail beschrieben wird, ist darauf hinzuweisen, das sie nicht auf die jeweiligen Bauteile der Schaltung oder Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

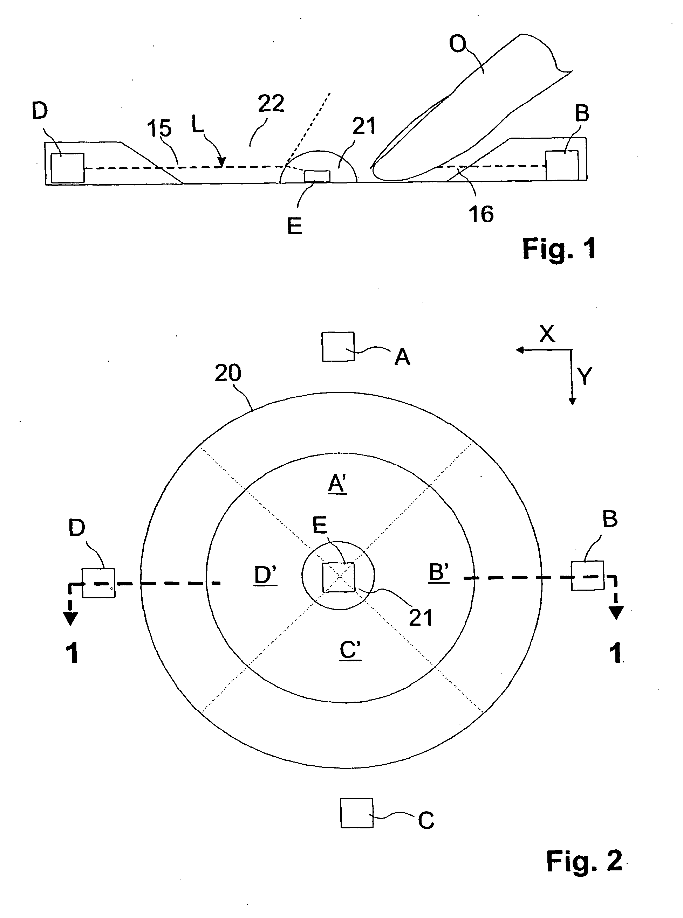

Die Figuren zeigen Ausführungsbeispiele einer optoelektronischen Vorrichtung zur Erfassung der Position und/oder Bewegung eines Objekts O mit wenigstens drei, in den Ausführungsbeispielen vier Sendern A, B, C und D. Diese Sender spannen, wie aus den gestrichelten Linien in Fig. 1 deutlich wird, eine mehrdimensionale Fläche auf, d.h. die Sender befinden sich z.B. in einer zweidimensionalen Fläche und dienen zur Aussendung von Strahlung, insbesondere von Lichtstrahlung. Grundsätzlich kann es sich bei der Strahlung um jede elektromagnetische Strahlung handeln, vorzugsweise handelt es sich jedoch um Licht mit einer Wellenlänge im sichtbaren oder unsichtbaren Bereich. Ebenso kann die durch die Anordnung der Sender bestimmte Fläche auch mehrdimensional sein.

Den Sendern A-D ist wenigstens ein Empfänger E zugeordnet, der für den Empfang der von den Sendern ausgesandten und vom Objekt O beeinflussbaren Strahlung vorgesehen ist. Zwischen wenigstens einem Teil der Sender A-D und wenigstens einem Empfänger E werden mehrere voneinander verschiedene Strahlungsstrecken gebildet, die gleichzeitig wenigstens ein der Fläche zugeordnetes Lichtfeld L, L' bilden, das vorzugsweise parallel zu einer Bedienoberfläche ist. Die Sender werden über eine Taktschaltung 30 taktweise angesteuert, um dadurch Strahlung in die verschiedenen Strahlungsstrecken einzubringen. Die Fläche ist im Bereich der Strahlungsstrecken angeordnet. In bekannter Weise werden die von dem wenigstens einem Empfänger E für die verschiedenen Strahlungsstrecken empfangenen Signale in Werte x, y zur Erfassung von Position und/oder Bewegung in einer Auswerteeinheit 11 umgesetzt.

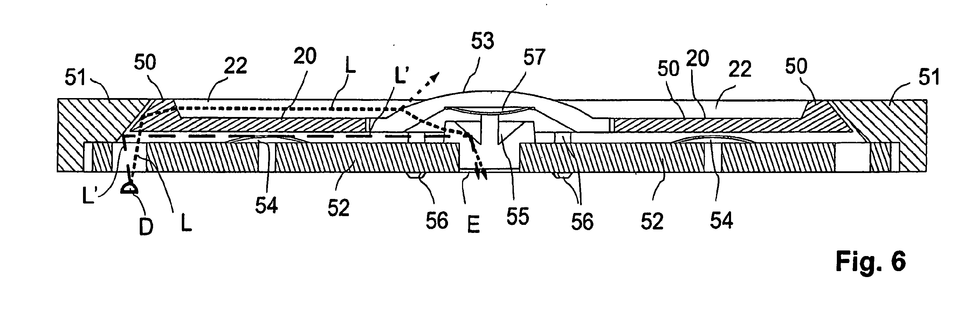

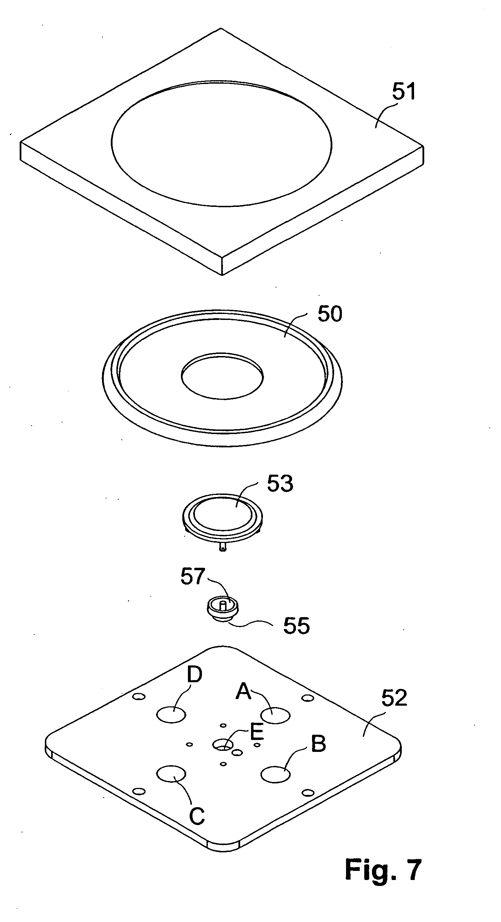

Das Lichtfeld L, ist in den beiden prinzipiell bekannten Beispielen der Fig. 1 bis 3 über der Bedienoberfläche 20 vorgesehen, die durch eine trichterförmige Ausnehmung 22 gebildet ist, in deren Grund der Empfänger E in einer kleinen ihn schützenden Auswölbung 21 angeordnet ist. Es ist auch möglich die Auswölbung 21 als ein reflektives Element auszubilden, das das einfallende Licht, bzw. die Strahlung der Sender in Richtung auf den Empfänger umlenkt, der dann z.B. unter der Bedienoberfläche angeordnet sein kann. In der Ausnehmung 22, in der auch das Lichtfeld L aufgespannt ist, kann sich zunächst das Objekt O frei bewegen, wobei seine Bewegung aufgrund der Empfangssignale am Empfänger E erfasst und in Werte x, y zur Erfassung der Position und/oder der Bewegung des Objekts umgesetzt wird. Ergänzend erfasst die Auswerteeinheit erfindungsgemäß als Mittel zur Erkennung einer absorptiven Unterbrechung, ob das Objekt O und/oder wie im Ausführungsbeispiel der Fig. 6 und 7 gezeigt, ein vom Objekt O betätigtes Betätigungselement 50 soweit in das Lichtfeld eintaucht, dass eine absorptive Unterbrechung wenigstens einer Strahlungsstrecke 15, 16 stattfindet. Diese absorptive Unterbrechung, die bezüglich der Strahlungsstrecke 16 in Figur 1 dargestellt ist, wird erkannt und als Betätigung einer Zusatzfunktion ausgewertet.

Vorzugsweise sind der wenigstens eine Empfänger E und die Sender A-D in einer Ebene angeordnet, d.h. in der Ebene, in der auch das Lichtfeld L in Fig. 1 aufgespannt ist. Vorzugsweise liegen die Austrittsöffnung(en) der Strahlung der Sender A-D in das Lichtfeld L, L' und die Eintrittsöffnung der Strahlung in den wenigstens einen Empfänger E in einer Ebene. Es können aber auch z.B. durch das Gehäuse 51 und das Betätigungselement 50 gebildete Umlenkmittel oder Reflektionsmittel vorgesehen sein, die die Strahlung in das Lichtfeld leiten und/oder aus dem Lichtfeld L, L' ableiten. Vorzugsweise wird wenigstens ein Lichtfeld L, L' so angeordnet, dass es parallel zur Bedienoberfläche 20 ist.

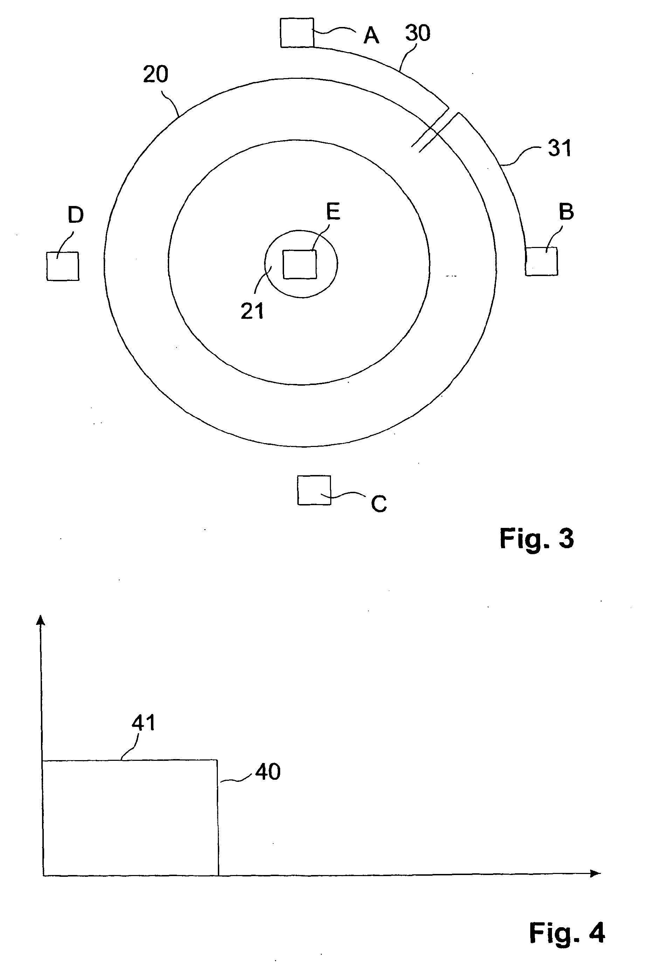

Für die Positionsbestimmung, also für die Bestimmung der x-, y-Werte genügen drei Sender, vorzugsweise wird jedoch eine geradlinige Anzahl an Sendern gewählt, da dies dem Benutzer von anderen Anwendungen her wie z.B. bei der Computermaus bekannt ist. In einer an sich bekanten Ausführung werden vier Sender gemäß Fig. 2, 3 kreuzartig angeordnet, während der Empfänger E mittig angeordnet ist. Bei dieser Anordnung ergibt sich eine Aufteilung in vier den jeweiligen Sendern A-D zugeordnete Felder A', B', C' und D', die in Fig. 2 durch gestrichelte Linien voneinander abgegrenzt sind. Der Empfänger kann jedoch auch außermittig angeordnet sein und ebenso können Signale auch über Lichtleiter zum Empfänger geleitet werden. Der Empfänger E ist z. B. gemäß Fig. 1 in oder unter einer aus der Bedienoberfläche 20 in das Lichtfeld ragenden Auswölbung 21 angeordnet, die zumindest für die Wellenlänge der Strahlung der Sender wenigstens teilweise durchlässig ist. Bevorzugt wird die Funktion der Auswölbung 21 durch einen Clickdom 53 eingenommen, auf den weiter unten noch näher eingegangen wird.

Die Bedienoberfläche 20 ist beispielsweise durch die Ausnehmung 22 gebildet, an deren Rand die Sender A-D angeordnet sind oder über deren Rand die Sender ihre Strahlung in das Lichtfeld L einbringen oder einreflektieren. Im ersten Fall des Einbringens können die Wandungen dieser Ausnehmung zumindest für die von den Sendern verwendete Strahlung teilweise durchlässig sein. Gleichzeitig ergibt sich ein abgeschlossener Raum, der zugleich eine Führung z.B. des Fingers erlaubt, wenn konkret eine bestimmte Position angesteuert werden soll.

Die erfindungsgemäße Ausführungsform gemäß den Figuren 6 und 7 erlaubt deutlich mehr Funktionalitäten. Das Betätigungselement 50 ist beweglich, vorzugsweise federelastisch in einem Gehäuse 51 gelagert. Die federelastische Abstützung kann z.B. über Clickelemente 54, 57 gegenüber einer Grundplatte 52 erfolgen. Von den Sendern ist nur der Sender D gezeigt. Sender und Empfänger E sind in oder unter der Grundplatte 52, wie z.B. einer Platine angeordnet. Die Bedienoberfläche 20, die hier auch eine Ausnehmung 22 aufweist, jedoch nicht aufweisen muss, ist auf der Oberseite des Betätigungselements 50 gebildet.

Im Ausführungsbeispiel ist das Betätigungselement 50 mehrteilig, es kann jedoch auch z.B. mit dem Clickdom 53 einstückig sein. Bedarfsweise können einzelne Elemente des Betätigungselements 50 z.B. über Filmscharniere oder dergleichen miteinander verbunden sein. Die auf der rechten Seite der Fig. 6 angedeuteten Strahlengänge machen deutlich, dass erfindungsgemäß Mittel vorgesehen sind, durch die die Strahlung in mehrere Lichtfelder aufgeteilt wird, von denen sich eines (L) über der Bedienoberfläche 20 und eines (L') unter dem Betätigungselement 50 befindet. Diese Mittel sind im Ausführungsbeispiel Umlenk- und Reflektionselemente wie das Gehäuse 21, das Betätigungselement 50, der Clickdom 53 oder das Umlenkelement 55.

Die Strahlung wird vom Sender D durch die Grundplatte 52 in Fig. 6 nach oben abgestrahlt. Zur Bildung des Lichtfelds L', das unter dem Betätigungselement 50 ausgebildet ist, wird das Licht z.B. an der nach innen geneigten Wandung des Gehäuses 51 reflektiert. Das Licht gelangt unter dem Betätigungselement 50 zu dem mittig angeordneten Umlenkelement 55 und wird von dort zum Empfänger E umgelenkt. Die vom Sender D kommende Strahlung wird auch durch das zumindest für die Wellenlänge der Strahlung transparente Betätigungselement 50 geleitet und an der Außenwandung des Betätigungselements oder der Wandung des Gehäuses 51 so umgelenkt, dass sich ausgehend vom gegenüber der Bedienoberfläche 20 erhabenem Rand des Betätigungselements 50 das Lichtfeld L über der Bedienoberfläche 20 aufgespannt wird. Das Licht trifft mittig auf den transparenten Clickdom 53, wobei dort ein Teil des Lichts nach oben reflektiert wird, was z.B. zur Bestimmung der Annäherung eines Objekts genutzt werden kann, während der andere Teil des Lichts durch den Clickdom 53 zum Umlenkelement und von dort zum Empfänger umgelenkt wird. Statt durch einen Sender können die verschiedenen Lichtfelder selbstverständlich auch durch mehrere Sender aufgebaut werden, wobei jeder Sender dem Lichtfeld L und dem Lichtfeld L' zugeordnet ist.

Bei dieser erfindungsgemäßen Ausgestaltung sind mit diesen Lichtfeldern L, L' zunächst folgende Erkennungen möglich. Über der Bedienoberfläche 20 kann die Bewegung und/oder Position des Objekts O im Lichtfeld L bestimmt werden. Es kann auch in diesem Lichtfeld eine absorptive Unterbrechung erkannt werden. Ferner kann die Position und/oder Bewegung des Betätigungselements im Lichtfeld L', meist durch eine Betätigung durch das Objekt O wie z.B. einen Finger ausgelöst ebenso erkannt werden, wie eine absorptive Unterbrechung im Lichtfeld L'. Die Clickelemente 54, 57 - hier sogenannte "Knackfrösche" - sind dem Betätigungselement 50 und/oder dem Clickdom zugeordnet und können zusätzlich als mechanische Schalter für die Bedienung weiterer Zusatzfunktionen genutzt werden, können aber wie im Ausführungsbeispiel auch nur als Federelemente für eine taktile Rückmeldung und/oder zur Abstützung des Betätigungselements 50 verwendet werden. Zusätzlich sind bedarfsweise mechanische Betätigungselemente 56 für die Bedienung weiterer Zusatzfunktionen vorgesehen.

Genügt die der Anzahl der Sender entsprechende Anzahl an Feldern für Zusatzfunktionen nicht, kann im Ausführungsbeispiel gemäß Fig. 3 eine Bildung von weiteren Feldern für Zusatzfunktionen mit Hilfe von Lichtleitern 30, 31 erfolgen. Zu diesem Zweck wird ein Teil des voneinander benachbarten Sendern A, B abgestrahlten Lichts an einen Übergangsbereich zwischen den beiden Sendern geleitet und von diesen in Richtung auf den Empfänger E abgestrahlt. Die Auswerteeinheit 11 erkennt nun bei einem "Eingriff" in die dadurch geschaffene zusätzliche Strahlungsstrecke zwischen dem Ende der Lichtleiter 30,31 und dem Empfänger E wiederum eine absorptive Unterbrechung durch Objekt O oder Betätigungselement 50 als weitere Zusatzfunktion, da in diesem Fall ein bekannter und den beiden Sendern zuordenbarer bestimmter Anteil des Lichts nicht an den Empfänger geleitet wird, was zu einem den beiden Sendern und dieser Art der absorptiven Unterbrechung zuordenbaren Signal in bestimmter Höhe führt, das als eine Betätigung einer weiteren Zusatzfunktion erkannt werden kann.

Vorzugsweise ist das Lichtfeld L parallel zur Bedienoberfläche 20 ausgebildet, grundsätzlich ist jedoch auch eine andere Anordnung des Lichtfeldes möglich. Die als Strahlungsstrecken 15,16 ausgebildeten Lichtstrecken werden wechselweise angesteuert, wobei die Auswerteeinheit 11 die Leistung der Sender mit einer Leistungsregelung vorzugsweise unverzüglich so regelt, dass am Empfänger ein Gleichlichtanteil ohne taktsynchronen Wechsellichtanteil ansteht.

Mit dieser Vorrichtung lassen sich damit nicht nur die Bewegungen des Objekts als Signal des Bedienelementes erkennen, sondern zusätzlich können tastenartig Zusatzfunktionen definiert und angesteuert werden. Es ergibt sich damit ein kompaktes Bedienelement.

Verfahrensgemäß wird die Strahlung von den Sendern ausgesandt, über einen Empfänger empfangen, wobei sich mehrere voneinander verschiedene Strahlungsstrecken ausbilden, die zwischen den Sendern und dem wenigstens einen Empfänger gebildet sind und wenigstens ein Lichtfeld bilden. Diese Strahlungsstrecken werden im Bereich einer Bedienoberfläche, vorzugsweise parallel zu ihr gebildet und taktweise wirksam geschaltet. Die beim Empfänger eingehenden Signale werden mittels einer Auswerteeinheit in bekannter Weise in x-und y-Werte zur Erfassung der Position und/oder der Bewegung des Objekts umgesetzt. Das der Bedienoberfläche zugeordnete Lichtfeld wird so eingesetzt, dass eine absorptive Unterbrechung wenigstens einer Strahlungstrecke durch das Objekt oder ein Betätigungselement als Zusatzfunktion, als Clickerkennung und/oder als taktile Rückmeldung von der Auswerteeinheit erkannt werden kann. Die Zusatzfunktionen sind als den Sendern A, B, C, D zugeordnete Felder A',B',C',D' in einer Ausnehmung angeordnet, so dass bei der Unterbrechung einer Strahlungsstrecke in dem jeweiligen Feld dies auch dem jeweiligen Sender zugeordnet werden kann. Bedarfsweise kann auch ein Teil benachbarter Sender über einen Lichtleiter in einen Bereich umgeleitet werden, so dass dort ein weiteres Zusatzfeld erzeugt wird. Gleichzeitig wird Licht von der Auswölbung 21 oder dem Clickdom 53 auch nach oben reflektiert und vom Objekt zurückreflektiert, so dass die Bewegung des Objekts erkannt werden kann. So kann z.B. durch eine Bewegung eines Finger durch Abrollen an der Auswölbung 21 oder dem Clickdom 53 oder durch Bewegung im Lichtfeld L ein Mauszeiger gesteuert werden. Wird der Finger zusätzlich so bewegt, dass sich eine absorptive Unterbrechung ergibt, kann dies als Anclicken ausgewertet werden.

Bei einer absorptiven Unterbrechung ergibt sich gemäß Fig. 4 ein deutlicher Abfall 40 des Empfangssignals 41, das dem jeweiligen Sender A, B, C, D zugeordnet werden kann.

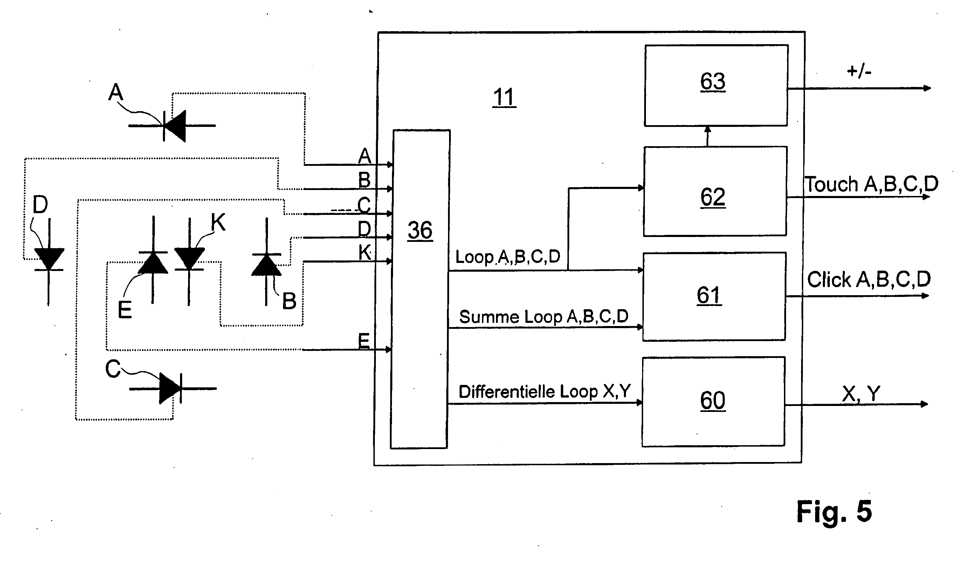

Fig. 5 zeigt ein zugehöriges Blockschaltbild. Die Sender A, B, C, D und der wenigstens eine Empfänger sind an eine Regeleinheit 36, bekannt als HALIOS, bezüglich der Ausgangssignale an die Sender und der Empfangssignale des Empfängers E gekoppelt. Ergänzend kann ein Kompensationselement K vorzugsweise in der Nähe des Empfängers E vorgesehen sein, wie es dem Fachmann aus dem Stand der Technik bekannt ist. Die Signale an das Kompensationselement K werden ebenfalls von der Regeleinheit beeinflusst. Die Regeleinheit ist Teil der Auswerteeinheit 11, die die Leistung der Sender und ggf. des Kompensationselement mit einer Leistungsregelung vorzugsweise unverzüglich so regelt, dass am Empfänger E ein Gleichlichtanteil ohne taktsynchronen Wechsellichtanteil ansteht.

Die in der Regeleinheit 36 vorliegenden Signale werden für sich, als Summe und als Differenz berechnet und in den Abschnitten Mauserkennung 60, Clickerkennung 61, Toucherkennung 62 und Richtungserkennung 63 ausgewertet. Bewegt sich das Objekt O im Lichtfeld O, ohne das es zu einer absorptiven Unterbrechung einer Lichtstrecke kommt, regelt die Regeleinheit 36 das Signal so aus, dass am Empfänger E ein Gleichlichtanteil ohne taktsynchronen Wechsellichtanteil ansteht. Dieses Ausregeln führt zu einem Differenzsignal, dass in der Mauserkennung 60 zur Bestimmung von x-, y-Koordinaten ausgewertet werden kann. Wird z.B. der Clickdom 53 oder das Betätigungselement 50 nach unten gedrückt, führt dies zu einer Änderung der Signale aus dem Lichtfeld L'. Dies kann durch den Summenwert aus allen Regelschleifen an sich erkannt werden. Dies allein genügt allerdings noch nicht, da noch nicht eindeutig bestimmt ist, ob alle Strahlungsstrecken oder nur einzelne Strahlungsstrecken unterbrochen wurden. Werden einzelne Strahlungsstrecken unterbrochen, wird dies in der Toucherkennung 62 erkannt. Werden diese Daten mit den summierten Daten in der Clickerkennung 61 korreliert, kann erkannt werden, ob eine Zusatzfunktion oder der Clickdom 53 - z.B. als eigene Funktion bei Unterbrechung aller Strahlungsstrecken - angeclickt wurde. Die Informationen aus der Toucherkennung 62 werden ergänzend in der Richtungserkennung 63 dahingehend überprüft, ob eine kreisförmige Bewegung des Objekts im Lichtfeld in oder gegen den Uhrzeigersinn erfolgt.

### Bezugszeichenliste

- 11: Auswerteeinheit
- 15,16: Strahlungsstrecke
- 20: Bedienoberfläche
- 21: Auswölbung
- 22: Ausnehmung
- 30,31: Lichtleiter
- 36: Regeleinheit
- 40: Abfall
- 41: Empfangssignals
- 50: Betätigungselement
- 51: Gehäuse
- 52: Grundplatte
- 53: Clickdom
- 54,57: Clickelement
- 55: Umlenkelement
- 56: mechanische Schalter
- 60: Mauserkennung
- 61: Clickerkennung
- 62: Toucherkennung
- 63: Richtungserkennung

- A,B,C,D: Sender
- A',B',C',D': Felder
- E: Empfänger
- L, L': Lichtfeld
- O: Objekt
- x,y: Werte der Position

## Patentansprüche

1. Optoelektronische Vorrichtung zur Erfassung der Position und/oder Bewegung eines Objekts (O) mit
- wenigstens drei Sendern (A,B,C,D) zur Aussendung von Strahlung, insbesondere Lichtstrahlung,
- wenigstens einem Empfänger (E) zum Empfang der von den Sendern (A-D) ausgesandten und vom Objekt (O) beeinflussbaren Strahlung,
- mehreren voneinander verschiedenen Strahlungsstrecken (15,16), die zwischen wenigstens einem Teil der Sender (A-D) und dem wenigstens einen Empfänger (E) gebildet sind und wenigstens ein Lichtfeld (L) bilden,
- einer Taktschaltung zur taktweisen Schaltung der Sender (A-D) der verschiedenen Strahlungsstrecken,
- einer im Bereich der Strahlungsstrecken angeordneten Bedienoberfläche (20),
- einer Auswerteeinheit (11), welche die von dem wenigstens einen Empfänger (E) für die verschiedenen Strahlungsstrecken empfangenen Signale in Werte (x, y) zur Erfassung der Position und/oder der Bewegung des Objekts (O) im Lichtfeld (L) umsetzt,
- wobei das Lichtfeld (L,) der Bedienoberfläche (20) zugeordnet ist
**dadurch gekennzeichnet, dass** die Auswerteinheit zur Bildung wenigstens einer Zusatzfunktion als ein Mittel zur Erkennung einer absorptiven Unterbrechung wenigstens einer Strahlungsstrecke (16) vorgesehen ist,
dass Mittel vorgesehen sind, durch die die Strahlung in mehrere Lichtfelder (L, L') aufgeteilt wird, von denen sich eines über der Bedienoberfläche (20) und eines unter dem Betätigungselement (50) befindet und
dass die Vorrichtung zur Detektion der Bewegung und/oder der Position des Objekts (O) im Lichtfeld (L) als auch zur Detektion der Position und/oder der Bewegung des Betätigungselements (50) selbst im Lichtfeld (L') vorgesehen ist,
- wobei die Auswerteinheit zur Bildung wenigstens einer Zusatzfunktion als ein Mittel zur Erkennung einer Unterbrechung wenigstens einer Strahlungsstrecke (16) im Lichtfeld (L) durch das Objekt (O) und/oder durch ein im Lichtfeld (L) angeordnetes oder in das Lichtfeld (L') einführbares Betätigungselement (50) ausgebildet ist.

2. Vorrichtung nach Anspruch 1, **dadurch gekennzeichnet, dass** Umlenkmittel oder Reflektionsmittel vorgesehen sind, die die Strahlung in wenigstens eines der Lichtfelder (L, L') leiten und/oder aus wenigstens einem der Lichtfelder (L, L') ableiten.

3. Vorrichtung nach einem der Ansprüche 1 oder 2, **dadurch gekennzeichnet, dass** das Lichtfeld (L, L') parallel zur Bedienoberfläche (20) ausgebildet ist.

4. Vorrichtung nach einem der vorhergehenden Ansprüche, **dadurch gekennzeichnet, dass** der Empfänger (E) in oder unter einer Auswölbung (21) bzw. in oder unter dem bedarfsweise mehrteiligen, vorzugsweise einen Clickdom (53) umfassenden Betätigungselement (50) angeordnet ist, die oder das aus der Bedienoberfläche (20) in das Lichtfeld (L) ragt und zumindest für die Wellenlänge der Strahlung wenigstens teilweise durchlässig ist.

5. Vorrichtung nach einem der vorhergehenden Ansprüche, **dadurch gekennzeichnet, dass** die Bedienoberfläche (20) in einer Ausnehmung (22) gebildet ist, an deren Rand die Sender (A-D) angeordnet sind oder über deren Rand die Sender ihre Strahlung in die Lichtfelder (L,L') einbringen.

6. Vorrichtung nach einem der vorhergehenden Ansprüche, **dadurch gekennzeichnet, dass** das Betätigungselement (50) beweglich, vorzugsweise federelastisch in einem Gehäuse (51) gelagert ist, wobei vorzugsweise Clickelemente (54,57) vorgesehen sind, die das Betätigungselement zur taktilen Rückmeldung lagern.

7. Vorrichtung nach einem der vorhergehenden Ansprüche, **dadurch gekennzeichnet, dass** die Bedienoberfläche (20) auf der Oberseite des Betätigungselements (50) gebildet ist.

8. Vorrichtung nach einem der vorhergehenden Ansprüche, **dadurch gekennzeichnet, dass** die als Strahlungsstrecken (15, 16) ausgebildeten Lichtstrecken wechselweise angesteuert sind und dass die Auswerteeinheit (11) die Leistung der Sender mit einer Leistungsregelung vorzugsweise unverzüglich so regelt, dass am Empfänger (E) ein Gleichlichtanteil ohne taktsynchronen Wechsellichtanteil ansteht.

9. Verfahren zur optoelektronischen Erfassung der Position und/oder Bewegung eines Objekts (O) mit den Schritten:
- Aussendung von Strahlung, insbesondere Lichtstrahlung mittels wenigstens drei Sendern (A,B,C,D),
- Empfangen der von den Sendern (A-D) ausgesandten und vom Objekt (O) beeinflussbaren Strahlung mittels wenigstens eines Empfänger (E) unter Bildung von mehreren voneinander verschiedenen Strahlungsstrecken (15,16), die zwischen wenigstens einem Teil der Sender (A-D) und dem wenigstens einen Empfänger (E) gebildet sind und wenigstens ein Lichtfeld (L, L') bilden,
- taktweises wirksam Schalten der Sender (A-D) der verschiedenen Strahlungsstrecken mittels einer Taktschaltung,
- Bilden einer im Bereich der Strahlungsstrecken angeordneten Bedienoberfläche (20),
- Auswerten der von dem wenigstens einen Empfänger (E) für die verschiedenen Strahlungsstrecken empfangenen Signale mittels einer Auswerteeinheit und Umsetzen der Signale in Werte (x, y) zur Erfassung der Position und/oder der Bewegung des Objekts (O) im Lichtfeld,
- Zuordnen des Lichtfelds (L, L') zur Bedienoberfläche (20),
**dadurch gekennzeichnet, dass** die Auswerteinheit eine absorptive Unterbrechung wenigstens einer Strahlungsstrecke (16) durch das Objekt (O) und/oder durch ein im Lichtfeld angeordnetes oder in das Lichtfeld einführbares Betätigungselement (50) als Zusatzfunktion erkennt,
dass die Strahlung so in die Vorrichtung eingestrahlt und/oder an einem Gehäuse (51) oder dem Betätigungselement (50) umgelenkt wird, dass sich zwischen Sender (A-D) und Empfänger (E) wenigstens zwei Lichtfelder (L, L') ausbilden, von denen sich eines über der Bedienoberfläche (20) und eines unter dem Betätigungselement (50) ausbildet, und
dass die Auswerteeinheit die Bewegung und/oder Position des Objekts (O) im Lichtfeld (L) als auch die Position und/oder Bewegung des Betätigungselements (50) selbst im Lichtfeld (L') detektiert,
- wobei die Auswerteinheit eine Unterbrechung wenigstens einer Strahlungsstrecke (16) durch das Objekt (O) und/oder durch ein im Lichtfeld (L) angeordnetes oder in das Lichtfeld (L') einführbares Betätigungselement (50) als Zusatzfunktion erkennt.

10. Verfahren nach Anspruch 9, **dadurch gekennzeichnet, dass** die Strahlung zur Bildung des Lichtfelds (L, L') umgelenkt oder reflektiert wird.

11. Verfahren nach einem der Ansprüche 9 bis 10, **dadurch gekennzeichnet, dass** das Lichtfeld (L, L') parallel zur Bedienoberfläche (20) von den Sendern abgestrahlt wird oder parallel zur Bedienoberfläche (20) umgelenkt wird.

12. Verfahren nach einem der Ansprüche 9 bis 11, **dadurch gekennzeichnet, dass** Licht an einer Auswölbung (21), dem Betätigungselement (50) oder an einem Clickdom (53) in Richtung von der Bedienoberfläche nach oben abgestrahlt und vom Objekt reflektiert wird.

13. Verfahren nach einem der Ansprüche 9 bis 12, **gekennzeichnet durch** die Anordnung der Bedienoberfläche (20) in einer Ausnehmung (22), an deren Rand die Sender (A-D) angeordnet sind oder über deren Rand die Sender ihre Strahlung in das Lichtfeld (L, L') einbringen.

14. Verfahren nach einem der Ansprüche 9 bis 13, **gekennzeichnet durch** die beweglich, vorzugsweise federelastische Lagerung des Betätigungselements (50) in einem Gehäuse (51).

15. Verfahren nach einem der Ansprüche 9 bis 14, **dadurch gekennzeichnet, dass** die als Strahlungsstrecken ausgebildeten Lichtstrecken wechselweise angesteuert werden und dass die Auswerteeinheit (11) die Leistung der Sender mit einer Leistungsregelung vorzugsweise unverzüglich so regelt, dass am Empfänger (E) ein Gleichlichtanteil ohne taktsynchronen Wechsellichtanteil ansteht.

## Claims

1. An optoelectronic device for detecting the position and/or the movement of an object (O), having
- at least three emitters (A,B,C,D) for emitting radiation, in particular light radiation,
- at least one receiver (E) for receiving the radiation which is emitted by the emitters (A-D) and which can be influenced by the object (O);
- a plurality of different radiation paths (15,16) which are formed between at least part of the emitters (A-D) and the at least one receiver (E), and which form at least one light field (L),
- a clock circuit for the clocked switching of the emitters (A-D) for the different radiation paths,
- an operator interface (20) located in the region of the radiation paths,
- an evaluation unit (11), which converts the signals received for the different radiation paths by the at least one receiver (E) into values (x, y) for detecting the position and/or the movement of the object (O) in the light field (L),
- wherein the light field (L,) is assigned to the operator interface (20)
**characterized in that**
the evaluation unit is provided for forming at least one additional function as a means for detecting an absorptive interruption of at least one radiation path (16),
that means are provided by means of which the radiation is divided into a plurality of light fields (L, L'), one of which is located above the user interface (20) and one below the actuator element (50), and
that the device is provided both for detecting the movement and/or the position of the object (0) in the light field (L) and for detecting the position and/or the movement of the actuator element (50) itself in the light field (L'),
- wherein the evaluation unit for forming at least one additional function is implemented as a means for detecting an interruption of at least one radiation path (16) in the light field (L) by the object (0) and/or by an actuator element (50) which is positioned in the light field (L) or can be introduced into the light field (L').

2. The device according to claim 1,
**characterized in that**
deflection means or reflection means are provided, which guide the radiation into at least one of the light fields (L, L') and/or conduct said radiation away from at least one of the light fields (L, L').

3. The device according to any one of claims 1 or 2,
**characterized in that**
the light field (L, L') is formed parallel to the operator interface (20).

4. The device according to any one of the preceding claims,
**characterized in that**
the receiver (E) is located in or under a convexity (21), or in or under the actuator element (50), possibly consisting of multiple parts as required and preferably comprising a Clickdom (53), either of which projects out of the operator interface (20) into the light box (L) and is at least partially transparent at least for the wavelength of the radiation.

5. The device according to any one of the preceding claims,
**characterized in that**
the operator interface (20) is formed in a recess (22), on the edge of which the emitters (A-D) are located or over the edge of which the emitters emit their radiation into the light fields (L,L').

6. The device according to any one of the preceding claims,
**characterized in that**
the actuator element (50) is movably, preferably resiliently mounted in a housing (51), wherein click elements (54,57) are preferably provided which support the actuator element for the purpose of tactile feedback.

7. The device according to any one of the preceding claims,
**characterized in that**
the operator interface (20) is formed on the top of the actuator element (50).

8. The device according to any one of the preceding claims,
**characterized in that**
the light paths implemented as radiation paths (15, 16) are activated alternately, and that the evaluation unit (11) regulates the power of the emitters with a power regulator preferably without a delay, such that a DC light component without a clock-synchronous AC light component appears at the receiver (E).

9. A method for the optoelectronic detection of the position and/or movement of an object (O), having the following steps:
- emitting of radiation, in particular light radiation, by means of at least three emitters (A,B,C,D),
- receiving of the radiation which is emitted by the emitters (A-D) and can be influenced by the object (O) by at least one receiver (E) by formation of a plurality of different radiation paths (15,16), which are formed between at least part of the emitters (A-D) and the at least one receiver (E) and which form at least one light field (L, L'),
- clocked switching of the emitters (A-D) for the different radiation paths using a clock circuit,
- forming of an operator interface (20) in the region of the radiation paths,
- evaluating the signals received by the at least one receiver (E) for the different radiation paths by means of an evaluation unit and converting the signals into values (x, y) for detecting the position and/or the movement of the object (0) in the light field,
- assigning the light field (L, L') to the operator interface (20),
**characterized in that**
the evaluation unit detects, as an additional function, an absorptive interruption of at least one radiation path (16) by the object (0) and/or by an actuator element (50) which is positioned in the light field or can be introduced into the light field,
that the radiation is irradiated into the device and/or deflected at a housing (51) or at the actuator element (50) in such a manner that at least two light fields (L, L') are formed between the emitter (A-D) and the receiver (E), one of which is formed above the operator interface (20) and one below the actuator element (50), and
that the evaluation unit detects the movement and/or position of the object (0) in the light field (1) as well as the position and/or movement of the actuator element (50) itself in the light field (L'),
- wherein the evaluation unit detects an interruption of at least one radiation path (16) by the object (0) and/or by an actuator element (50) which is positioned in the light field (L) or can be inserted into the light field (L') as an additional function.

10. The method according to Claim 9,
**characterized in that**
in order to form the light field (L, L') the radiation is deflected or reflected.

11. The method according to any one of claims 9 to 10,
**characterized in that**
the light field (L, L') is radiated by the emitters parallel to the operator interface (20), or is deflected parallel to the operator interface (20).

12. The method according to any one of claims 9 to 11,
**characterized in that**
light is radiated upwards at a convexity (21), the actuator element (50) or at a Clickdom (53) in the direction of the operator interface and reflected from the object.

13. The method according to any one of claims 9 to 12,
**characterized by** the location of the operator interface (20) in a recess (22), at the edge of which the emitters (A-D) are located, or over the edge of which the emitters emit their radiation into the light field (L, L').

14. The method according to any one of claims 9 to 13,
**characterized by** the movable, preferably resilient mounting of the actuator element (50) in a housing (51).

15. The method according to any one of claims 9 to 14,
**characterized in that**
the light paths implemented as radiation paths are activated alternately, and that the evaluation unit (11) regulates the power of the emitters with a power regulator preferably without a delay, such that a DC light component without a clock-synchronous AC light component appears at the receiver (E).

## Revendications

1. Dispositif opto-électronique pour détecter la position et/ou le mouvement d'un objet (0), comportant :
- au moins trois émetteurs (A, B, C, D) pour l'émission d'un rayonnement, en particulier d'un rayonnement lumineux ;
- au moins un récepteur (E) pour la réception du rayonnement émis par les émetteurs (A-D) et pouvant être influencé par l'objet (O) ;
- plusieurs parcours de rayonnement (15, 16) différents les uns des autres qui sont formés entre au moins une partie des émetteurs (A-D) et l'au moins un récepteur (E) et forment au moins un champ lumineux (L) ;
- un circuit d'horloge pour la commande cadencée des émetteurs (A-D) des différents parcours de rayonnement ;
- une surface de commande (20) située dans la zone des parcours de rayonnement ;
- une unité d'évaluation (11) qui convertit les signaux reçus par l'au moins un récepteur (E) pour les différents parcours de rayonnement en valeurs (x, y) afin de détecter la position et/ou le mouvement de l'objet (O) dans le champ lumineux (L) ;
- le champ lumineux (L) étant associé à la surface de commande (20) ;
**caractérisé en ce que** :
- l'unité d'évaluation destinée à former au moins une fonction supplémentaire est prévue en tant que moyen de reconnaissance d'une interruption absorbante d'au moins un parcours de rayonnement (16) ;
- sont prévus des moyens permettant de séparer le rayonnement en plusieurs champs lumineux (L, L') dont un se trouve au-dessus de la surface de commande (20) et un, en dessous de l'élément d'actionnement (50) ; et
- le dispositif est prévu non seulement pour la détection du mouvement et/ou de la position de l'objet (O) dans le champ lumineux (L), mais aussi pour la détection de la position et/ou du mouvement de l'élément d'actionnement (50) lui-même dans le champ lumineux (L') ;
l'unité d'évaluation destinée à former au moins une fonction supplémentaire étant réalisée en tant que moyen de reconnaissance d'une interruption d'au moins un parcours de rayonnement (16) dans le champ lumineux (L) par l'objet (O) et/ou par un élément d'actionnement (50) situé dans le champ lumineux (L) ou pouvant être introduit dans le champ lumineux (L').

2. Dispositif selon la revendication 1, **caractérisé en ce que** sont prévus des moyens de déviation ou de réflexion qui dirigent le rayonnement vers au moins l'un des champs lumineux (L, L') et/ou le font sortir d'au moins l'un des champs lumineux (L, L').

3. Dispositif selon l'une des revendications 1 ou 2, **caractérisé en ce que** le champ lumineux (L, L') est réalisé parallèlement à la surface de commande (20).

4. Dispositif selon l'une des revendications précédentes, **caractérisé en ce que** le récepteur (E) est situé dans ou sous une convexité (21) respectivement dans ou sous l'élément d'actionnement (50) qui est réalisé en plusieurs pièces si nécessaire et comporte de préférence une calotte à déclic (53), laquelle convexité ou lequel élément d'actionnement font saillie dans le champ lumineux (L) par rapport à la surface de commande (20) et sont au moins en partie perméables à la longueur d'onde du rayonnement.

5. Dispositif selon l'une des revendications précédentes, **caractérisé en ce que** la surface de commande (20) est réalisée dans un évidement (22) sur le bord duquel sont agencés les émetteurs (A-D) ou via le bord duquel les émetteurs envoient leur rayonnement dans les champs lumineux (L, L').

6. Dispositif selon l'une des revendications précédentes, **caractérisé en ce que** l'élément d'actionnement (50) est logé mobile, de préférence de manière élastique, dans un boîtier (51), des éléments à déclic (54, 57) qui logent l'élément d'actionnement pour une rétroaction tactile étant de préférence prévus.

7. Dispositif selon l'une des revendications précédentes, **caractérisé en ce que** la surface de commande (20) est formée sur la partie supérieure de l'élément d'actionnement (50).

8. Dispositif selon l'une des revendications précédentes, **caractérisé en ce que** les parcours lumineux réalisés en tant que parcours de rayonnement (15, 16) sont commandés alternativement et **en ce que** l'unité d'évaluation (11) règle de préférence sans délai la puissance des émetteurs avec une régulation de puissance telle qu'une composante de lumière continue sans composante de lumière alternative synchrone est appliqué sur le récepteur (E).

9. Procédé de détection opto-électronique de la position et/ou du mouvement d'un objet (O), comportant les étapes suivantes :
- émission d'un rayonnement, en particulier d'un rayonnement lumineux, au moyen d'au moins trois émetteurs (A, B, C, D) ;
- réception du rayonnement émis par les émetteurs (A-D) et pouvant être influencé par l'objet (O) au moyen d'au moins un récepteur (E) avec formation de plusieurs parcours de rayonnement (15, 16) différents les uns des autres qui sont formés entre au moins une partie des émetteurs (A-D) et l'au moins un récepteur (E) et forment au moins un champ lumineux (L, L') ;
- activation cadencée des émetteurs (A-D) des différents parcours de rayonnement au moyen d'un circuitd'horloge;
- formation d'une surface de commande (20) située dans la zone des parcours de rayonnement ;
- évaluation, au moyen d'une unité d'évaluation, des signaux reçus par l'au moins un récepteur (E) pour les différents parcours de rayonnement et conversion des signaux en valeurs (x, y) afin de détecter la position et/ou le mouvement de l'objet (O) dans le champ lumineux ;
- association du champ lumineux (L, L') à la surface de commande (20) ;
**caractérisé en ce que** l'unité d'évaluation reconnaît, en tant que fonction supplémentaire, une interruption absorbante d'au moins un parcours de rayonnement (16) par l'objet (O) et/ou par un élément d'actionnement (50) situé dans le champ lumineux ou pouvant être introduit dans le champ lumineux ;
le rayonnement entre de manière telle dans le dispositif et/ou est dévié de manière telle sur le boîtier (51) ou sur l'élément d'actionnement (50) qu'il se forme, entre les émetteurs (A-D) et le récepteur (E), au moins deux champs lumineux (L, L') dont un se forme au-dessus de la surface de commande (20) et un, en dessous de l'élément d'actionnement (50) ;
le dispositif d'évaluation détecte non seulement le mouvement et/ou la position de l'objet (O) dans le champ lumineux (L), mais aussi la position et/ou le mouvement de l'élément d'actionnement (50) lui-même dans le champ lumineux (L') ;
- l'unité d'évaluation reconnaissant, en tant que fonction supplémentaire, une interruption d'au moins un parcours de rayonnement (16) par l'objet (O) et/ou par un élément d'actionnement (50) situé dans le champ lumineux (L) ou pouvant être introduit dans le champ lumineux (L').

10. Procédé selon la revendication 9, **caractérisé en ce que** le rayonnement destiné à former le champ lumineux (L, L') est dévié ou réfléchi.

11. Procédé selon l'une des revendications 9 à 10, **caractérisé en ce que** le champ lumineux (L, L') est émis par les émetteurs parallèlement à la surface de commande (20) ou est dévié parallèlement à la surface de commande (20).

12. Procédé selon l'une des revendications 9 à 11, **caractérisé en ce que** de la lumière est, au niveau d'une convexité (21), de l'élément d'actionnement (50) ou d'une calotte à déclic (53), rayonnée vers le haut en direction de la surface de commande et est réfléchie par l'objet.

13. Procédé selon l'une des revendications 9 à 12, **caractérisé par** l'agencement de la surface de commande (20) dans un évidement (22) sur le bord duquel sont agencés les émetteurs (A-D) ou via le bord duquel les émetteurs envoient leur rayonnement dans le champ lumineux (L, L').

14. Procédé selon l'une des revendications 9 à 13, **caractérisé par** le logement mobile, de préférence élastique, de l'élément d'actionnement (50) dans un boîtier (51).

15. Procédé selon l'une des revendications 9 à 14, **caractérisé en ce que** les parcours lumineux réalisés en tant que parcours de rayonnement sont commandés alternativement et **en ce que** l'unité d'évaluation (11) règle de préférence sans délai la puissance des émetteurs avec une régulation de puissance telle qu'une composante de lumière continue sans composante de lumière alternative synchrone est appliquée sur le récepteur.
